(19) **Europäisches Patentamt / European Patent Office / Office européen des brevets**

(11) **EP 2 832 511 B1**

(12) **EUROPEAN PATENT SPECIFICATION**

(45) Date of publication and mention of the grant of the patent:
**01.06.2016 Bulletin 2016/22**

(21) Application number: **12872703.9**

(22) Date of filing: **29.03.2012**

(51) Int Cl.:
**B28B 3/26** (2006.01)   **C23C 14/06** (2006.01)
**C23C 14/48** (2006.01)   **C23C 8/24** (2006.01)
**C23C 8/36** (2006.01)   **C23C 8/12** (2006.01)
**B23H 1/00** (2006.01)   **B23P 15/24** (2006.01)
**B28B 3/20** (2006.01)   **B29C 47/00** (2006.01)
**B29C 47/12** (2006.01)   **B29C 47/30** (2006.01)
**C04B 35/565** (2006.01)   **C04B 38/00** (2006.01)
**C23C 14/02** (2006.01)   **C23C 14/04** (2006.01)
**C23C 8/02** (2006.01)   **C23C 8/80** (2006.01)

(86) International application number:
**PCT/JP2012/058374**

(87) International publication number:
**WO 2013/145215 (03.10.2013 Gazette 2013/40)**

(54) **DIE FOR EXTRUSION MOLDING, PRODUCTION METHOD FOR DIE FOR EXTRUSION MOLDING, AND PRODUCTION METHOD FOR HONEYCOMB STRUCTURE**

STRANGPRESSWERKZEUG, HERSTELLUNGSVERFAHREN FÜR EIN STRANGPRESSWERKZEUG UND HERSTELLUNGSVERFAHREN FÜR EINE WABENSTRUKTUR

FILIÈRE POUR MOULAGE PAR EXTRUSION, PROCÉDÉ DE FABRICATION DE FILIÈRE POUR MOULAGE PAR EXTRUSION ET PROCÉDÉ DE FABRICATION DE STRUCTURE EN NID D'ABEILLES

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**04.02.2015 Bulletin 2015/06**

(73) Proprietor: **Ibiden Co., Ltd**
**Ogaki-shi, Gifu 503-8604 (JP)**

(72) Inventors:
• **ANDO Kiyotaka**
**Anpachi-gun**
**Gifu 503-2321 (JP)**
• **KAWANO Shuichi**
**Anpachi-gun**
**Gifu 503-2321 (JP)**

• **ASAI Makoto**
**Ibi-gun**
**Gifu 501-0695 (JP)**

(74) Representative: **Hoefer & Partner Patentanwälte mbB**
**Pilgersheimer Straße 20**
**81543 München (DE)**

(56) References cited:
**EP-A1- 2 305 857          JP-A- H08 276 487**
**JP-A- 2008 188 795     JP-A- 2009 196 251**
**JP-A- 2009 196 252     JP-A- 2010 024 518**
**US-A1- 2007 164 456**

**EP 2 832 511 B1**

**Description**

TECHNICAL FIELD

The present invention relates to a die for extrusion molding, a method of producing a die for extrusion molding, and a method of producing a honeycomb structured body.

BACKGROUND ART

Exhaust gases discharged from internal combustion engines of vehicles (e.g., buses, trucks) and construction machines contain particulate matter, such as soot. Particulate matter has been a problem as it is harmful to the environment and human body. Thus, various particulate filters which include honeycomb structured bodies formed of porous ceramic are proposed. Those filters purify exhaust gases by capturing particulate matter in exhaust gases.

For achieving excellent heat resistance and strength, such a honeycomb structured body includes a plurality of prismatic honeycomb fired bodies which are combined with one another with adhesive layers provided therebetween. The honeycomb fired bodies are produced by subjecting a mixture containing ceramic materials (e.g., silicon carbide) to, for example, extrusion molding, degreasing, firing, or other treatments.

Generally, in the production of honeycomb structured bodies, a molding raw material is extrusion molded through a die for extrusion molding to produce a honeycomb molded body including a large number of cells which are separated by cell walls and are arranged in parallel with one another in a longitudinal direction.

One example of known dies for extrusion molding for producing honeycomb molded bodies is a die that includes raw material supply sections for supplying a molding raw material, and slit grooves for forming the molding raw material into a honeycomb molded body. The slit grooves communicate with the raw material supply sections and are arranged in a lattice pattern.

Regarding a method for machining a material of a die into the aforementioned shape, machining with a cutting tool, such as a drill, is widely performed (Patent Literature 1), for example. In the case where the material of a die consists of a hard ingredient, such as a superhard alloy, or a die to be produced has a complex shape, the machining is performed by electrical discharge machining.

CITATION LIST

- Patent Literature

Patent Literature 1: JP H05-131425 A

SUMMARY OF INVENTION

- Technical Problem

The die (Patent Literature 1) produced by machining with a cutting tool, such as a drill, has a machining-affected layer including many cracks on the machined sites. A die produced by electrical discharge machining has a machining-affected layer including defects (e.g., cracks, small pores) on the machined sites.

The machining-affected layers herein refer to surface layers where the quality of the material is changed by the machining. The change may be caused by, for example, mechanical energy, thermal energy, or combination of mechanical energy and thermal energy.

Such a machining-affected layer is very fragile. Thus, after repeated extrusion molding of molding raw materials through the die, the surface of the die is likely to be worn away by abrasion due to contacts between molding raw materials and the surface of the die. In particular, in the case of using a molding raw material consisting mainly of hard ingredients, such as silicon carbide powders, the surface of the die is more likely to be worn away. Honeycomb molded bodies extrusion molded through the die have thick cell walls, and thus are not formed into designed shapes. The die in such a condition cannot be appropriately used any more, and thus unfortunately has a shorter life.

The present invention is devised to solve the above problem, and aims to provide a die for extrusion molding, a method of producing a die for extrusion molding, and a method of producing a honeycomb structured body, that can achieve excellent abrasion resistance and a longer life of the die.

- Solution to Problem

A die for extrusion molding according to claim 1 is devised to achieve the above goal. The die includes: a first

2

face; a second face formed opposite the first face; a raw material supply section with a first through hole that extends from the first face toward the second face; and a molding section with a second through hole that extends from the second face toward the first face so as to communicate with the first through hole, wherein the die is obtainable through the steps of: machining a material of the die to form the material into a predetermined shape and to form a machining-affected layer on the inner wall surface of the second through hole in the molding section; forming an oxidized layer by heating the machining-affected layer to oxidize the layer so as to convert the machining-affected layer into an oxidized layer; removing the oxidized layer so that a treated surface is formed; and nitriding the treated surface by ion implantation to form a nitride layer.

A less fragile treated surface is provided on the inner wall surface of the second through hole when the treated surface is formed through the steps of forming an oxidized layer and removing the oxidized layer. Moreover, the nitride layer that is formed on the treated surface through the nitriding step further increases the hardness of the inner wall surface of the second through hole. The inner wall surface of the second through hole is less likely to be worn away even after repeated extrusion molding of molding raw materials. Thus, the life of the die can be increased.

An increase in the life of the die means preventing abrasion of the inner wall surface of the second through hole during use of the die to avoid an increase in the thickness of the cell walls of extrusion molded honeycomb molded bodies, and also means preventing uneven abrasion of the inner wall surface of the second through hole during use of the die to avoid uneven thickness of the cell walls of extrusion molded honeycomb molded bodies.

In a die for extrusion molding according to claim 2, the raw material supply section further has a first opening formed at the first face and a second opening formed at a part where the second through hole communicates with the first through hole, and the width of the raw material supply section decreases from the first opening toward the second opening.

If the width of the raw material supply section decreases from the first opening toward the second opening, a molding raw material readily flows from the raw material supply section to the molding section. Thus, the molding raw material is prevented from clogging in the die for extrusion molding.

In a die for extrusion molding according to claim 3, the molding section includes slit grooves that communicate with a plurality of the second through holes, the slit grooves connecting to one another to form a lattice pattern.

If the molding section includes slit grooves that communicate with a plurality of the second through holes, the slit grooves connecting to one another to form a lattice pattern, extrusion molding of a molding raw material through the die for extrusion molding enables a honeycomb molded body having a large number of cells that are separated by cell walls and are arranged in parallel with one another in a longitudinal direction.

A die for extrusion molding according to claim 4 is obtainable further through the steps of: machining a material of the die to form the material into a predetermined shape and to form a machining-affected layer on the inner wall surface of the first through hole in the raw material supply section; forming an oxidized layer by heating the machining-affected layer to oxidize the layer so as to convert the machining-affected layer into an oxidized layer; removing the oxidized layer so that a treated surface is formed; and nitriding the treated surface by ion implantation to form a nitride layer.

A less fragile treated surface is provided on the inner wall surface of the first through hole when the treated surface is formed through the steps of forming an oxidized layer and removing the oxidized layer. Moreover, the nitride layer that is formed on the treated surface through the nitriding step further increases the hardness of the inner wall surface of the first through hole. The inner wall surface of the first through hole is much less likely to be worn away even after repeated extrusion molding of molding raw materials. Thus, the first through hole can maintain the shape that allows a molding raw material to readily flow from the raw material supply section to the molding section. As a result, the molding raw material is prevented from clogging in the die for extrusion molding even after repeated extrusion molding of molding raw materials.

In a die for extrusion molding according to claim 5, the nitride layer has a thickness of 5 to 1000 nm.

If the nitride layer has a thickness of 5 to 1000 nm, the inner wall surface of the second through hole can long maintain the abrasion resistance in the molding section. Thus, the life of the die can be further increased.

A nitride layer having a thickness of less than 5 nm is too thin and may be shortly worn away.

A nitride layer having a thickness of more than 1000 nm increases stress on the nitride layer upon extruding a molding raw material. Thus, cracks may occur in the inner wall surface of the second through hole in the molding section.

In a die for extrusion molding according to claim 6, the nitride layer has a hardness of 1200 to 3000 Hv.

A nitride layer having a hardness of 1200 to 3000 Hv prevents abrasion of the inner wall surface of the second through hole in the molding section even after repeated extrusion molding of molding raw materials. Thus, the life of the die can be further increased.

A nitride layer having a hardness of less than 1200 Hv may not readily achieve the effect of the present invention because of the insufficient hardness.

A nitride layer having a hardness of more than 3000 Hv increases stress on the nitride layer upon extruding a molding raw material. Thus, cracks may occur in the inner wall surface of the second through hole in the molding section.

A die for extrusion molding according to claim 7 is made of a superhard alloy that includes a sintered mixture of tungsten carbide and cobalt, and the nitride layer includes tungsten carbonitride.

If the die for extrusion molding is made of a superhard alloy that includes a sintered mixture of tungsten carbide and cobalt, and the nitride layer includes tungsten carbonitride, the inner wall surface of the second through hole has higher hardness. This prevents abrasion of the inner wall surface of the second through hole in the molding section even after repeated extrusion molding of molding raw materials. Thus, the life of the die can be further increased.

In a die for extrusion molding according to claim 8, the step of removing the oxidized layer is performed by flow polishing.

The step of removing the oxidized layer by flow polishing enables a treated surface where the oxidized layer is sufficiently removed. Such a treated surface is less fragile than the machining-affected layer. The inner wall surface of the second through hole where a nitride layer is formed on the treated surface is much less likely to be worn away even after repeated extrusion molding of molding raw materials. Thus, the life of the die can be further increased.

In a die for extrusion molding according to claim 9, a molding raw material to be introduced to the raw material supply section includes silicon carbide.

Even if the molding raw material includes silicon carbide, which is very hard, the inner wall surface of the second through hole is less likely to be worn away. Thus, the life of the die can be increased.

In a method of producing a die for extrusion molding according to claim 10, the die includes: a first face; a second face formed opposite the first face; a raw material supply section with a first through hole that extends from the first face toward the second face; and a molding section with a second through hole that extends from the second face toward the first face so as to communicate with the first through hole, the method including the steps of: machining a material of the die to form the material into a predetermined shape and to form a machining-affected layer on the inner wall surface of the second through hole in the molding section; forming an oxidized layer by heating the machining-affected layer to oxidize the layer so as to convert the machining-affected layer into an oxidized layer; removing the oxidized layer so that a treated surface is formed; and nitriding the treated surface by ion implantation to form a nitride layer.

In the step of forming an oxidized layer, the machining-affected layer is heated so that the machining-affected layer is gradually oxidized from the surface to the inside. As a result, an oxidized layer with excellent peelability is formed. Thus, in the step of removing the oxidized layer, the oxidized layer can be readily removed to obtain a treated surface.

The nitriding step for forming a nitride layer by nitrogen ion implantation enables formation of a uniform nitride layer. In particular, even if the machined die has a complex shape, the nitride layer can be uniformly formed. Formation of the uniform nitride layer enables favorable production of the die for extrusion molding of the present invention.

In a method of producing a die for extrusion molding according to claim 11, the machining step is performed by die-sinking electrical discharge machining.

If the machining step is performed by die-sinking electrical discharge machining, the material of the die, even if it is a hard material, can be favorably machined into a predetermined shape. Moreover, if the machining step is performed by die-sinking electrical discharge machining, the material can be favorably machined into the shape of the die to be produced even if the shape is complex.

In a method of producing a die for extrusion molding according to claim 12, in the step of forming an oxidized layer, the machining-affected layer is heated to a temperature of 500 to 1000°C in an oxygen atmosphere.

Heating the machining-affected layer to a temperature of 500 to 1000°C in an oxygen atmosphere can sufficiently oxidize the machining-affected layer.

If the machining-affected layer is heated to a temperature of less than 500°C, the machining-affected layer may not be sufficiently oxidized.

If the machining-affected layer is heated to a temperature of more than 1000°C, the quality of the material of the die beneath the machining-affected layer may be changed. Thus, the die may fail to have intrinsic physical properties.

In a method of producing a die for extrusion molding according to claim 13, in the step of forming an oxidized layer, the machining-affected layer is heated to a predetermined temperature of 500 to 1000°C in a nitrogen atmosphere; and the heated machining-affected layer is left stand at the predetermined temperature in an oxygen atmosphere for 5 to 180 minutes.

Dies for extrusion molding used to produce honeycomb molded bodies need to have high dimensional accuracy.

In the step of forming an oxidized layer, the oxidation includes introduction of oxygen after the heating and then maintenance of a given temperature. Thus, the oxygen concentration can be controlled during the oxidation. As a result, an oxidized layer with a uniform thickness can be formed, which in turn can produce a die with a high dimensional accuracy.

In a method of producing a die for extrusion molding according to claim 14, the step of removing the oxidized layer is performed by flow polishing.

If the step of removing the oxidized layer is performed by flow polishing, the oxidized layer can be readily removed.

A method of producing a honeycomb structured body according to claim 15 includes the steps of: extrusion molding a molding raw material through a die for extrusion molding to produce at least one honeycomb molded body that includes a large number of cells, the cells being separated by cell walls and arranged in parallel with one another in a longitudinal direction; firing the at least one honeycomb molded body to produce at least one honeycomb fired body; and producing a ceramic block of the at least one honeycomb fired body, the die including: a first face; a second face formed opposite the first face; a raw material supply section with a first through hole that extends from the first face toward the second face; and a molding section with a second through hole that extends from the second face toward the first face so as to communicate with the first through hole, wherein the die is obtainable through the steps of: machining a material of the die to form the material into a predetermined shape and to form a machining-affected layer on the inner wall surface of the second through hole in the molding section; forming an oxidized layer by heating the machining-affected layer to oxidize the layer so as to convert the machining-affected layer into an oxidized layer; removing the oxidized layer so that a treated surface is formed; and nitriding the treated surface by ion implantation to form a nitride layer.

In the method of producing a honeycomb structured body according to claim 15, an increase and variation in the thickness of the cell walls of a honeycomb molded body can be prevented during the step to produce at least one honeycomb molded body. Thus, a honeycomb structured body can be favorably produced.

BRIEF DESCRIPTION OF DRAWINGS

Fig. 1(a) is a cross-sectional view schematically illustrating one example of a die for extrusion molding according to the first embodiment of the present invention. Fig. 1(b) is a partially enlarged view of the die for extrusion molding shown in Fig. 1(a).

Fig. 2 is a graph showing one example of the results of a secondary ion mass spectrometry on the surface of the slit groove of the die for extrusion molding according to the first embodiment of the present invention.

Fig. 3 is a cross-sectional view schematically illustrating slit grooves when the material of the die for extrusion molding according to the first embodiment of the present invention includes a superhard alloy.

Fig. 4 is an enlarged front view of the die for extrusion molding shown in Fig. 1(a).

Figs. 5(a) to 5(d) are each a cross-sectional view schematically showing a method of producing a die for extrusion molding according to the first embodiment of the present invention.

Fig. 6 is an SEM image of a cross-section of a surface of a slit groove after the machining step in the method of producing a die for extrusion molding according to the first embodiment of the present invention.

Fig. 7 is a perspective view schematically illustrating one example of a honeycomb molded body that is extrusion molded through the die for extrusion molding according to the first embodiment of the present invention.

Fig. 8 (a) is a perspective view schematically illustrating one example of a honeycomb fired body to be produced using the die for extrusion molding according to the present embodiment. Fig. 8(b) is an A-A line cross-sectional view of the honeycomb fired body shown in Fig. 8(a).

Fig. 9 is a perspective view schematically illustrating one example of a honeycomb structured body that is produced using the die for extrusion molding according to the present embodiment.

DESCRIPTION OF EMBODIMENTS

Embodiments of the present invention will be specifically described below. However, the present invention is not limited to those embodiments, and may be appropriately changed to an extent not changing the gist of the present invention.

(First embodiment)

The following describes the die for extrusion molding according to the first embodiment of the present invention, and the method of producing a die for extrusion molding and the method of producing a honeycomb structured body according to the first embodiment, which is one embodiment of the present invention, with reference to drawings.

First, a die for extrusion molding according to the present embodiment will be described.

The die for extrusion molding of the present embodiment includes: a first face; a second face formed opposite the first face; a raw material supply section with a first through hole that extends from the first face toward the second face; and a molding section with a second through hole that extends from the second face toward the first face so as to communicate with the first through hole, wherein the die is obtainable through the steps of: machining a material of the die to form the material into a predetermined shape and to form a machining-affected layer on the inner wall surface of the second through hole in the molding section; forming an oxidized layer by heating the machining-affected layer to oxidize the layer so as to convert the machining-affected layer into an oxidized layer; removing the oxidized layer so that a treated surface is formed; and nitriding the treated surface by ion implantation to form a nitride layer.

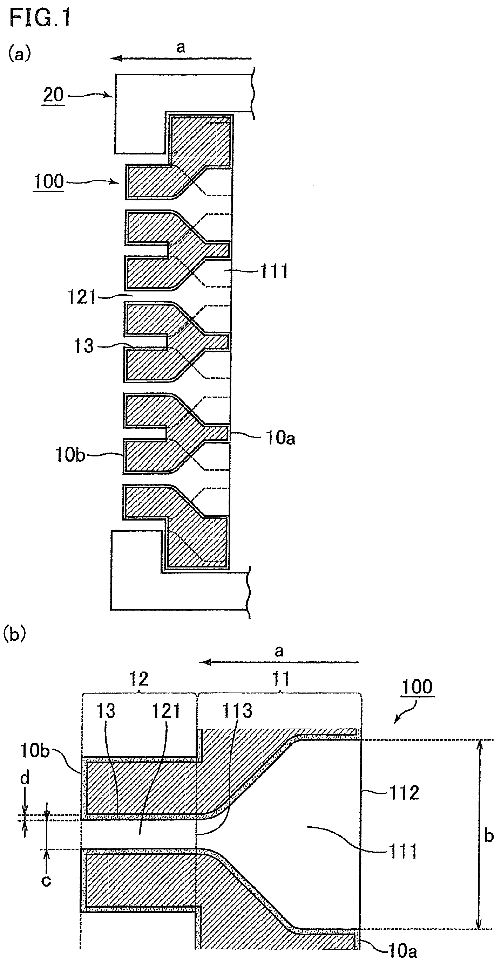

Fig. 1(a) is a cross-sectional view schematically illustrating one example of a die for extrusion molding according to the first embodiment of the present invention. Fig. 1(b) is a partially enlarged view of the die for extrusion molding shown in Fig. 1(a).

Fig. 1(a) and Fig. 1(b) are cross-sectional views of a die for extrusion molding illustrated in a direction parallel to the direction of extruding a molding raw material. The arrow "a" in Fig. 1(a) and Fig. 1(b) indicates the direction of extruding a molding raw material.

As shown in Fig. 1(a) and Fig. 1(b), a die for extrusion molding 100 includes a first face 10a; a second face 10b formed opposite the first face 10a; a raw material supply section 11 with a first through hole 111 that extends from the first face 10a toward the second face 10b; and a molding section 12 with a second through hole 121 that extends from the second face 10b toward the first face 10a so as to communicate with the first through hole 111. The molding section 12 includes slit grooves that communicate with a plurality of the second through holes 121, the slit grooves connecting to one another to form a lattice pattern.

The raw material supply section 11 is formed to supply a molding raw material. The molding section 12 is formed to form a molding raw material passed through the raw material supply section 11 into the shape of a honeycomb molded body.

An outer frame 20 for immobilizing the die for extrusion molding 100 may be provided as needed.

In the following description, the inner wall surfaces of the second through holes 121 in the molding section 12 correspond to the surfaces of the slit grooves 12.

A nitride layer 13 is formed on the surfaces of the slit grooves 12.

The nitride layer 13 formed on the surfaces of the slit grooves 12 is an essential element of the die for extrusion molding according to the present embodiment. In addition to the essential element, the nitride layer 13 may also be formed on the inner wall surface of the first through hole 111, the first face 10a, the second face 10b, or other parts in the raw material supply section 11 as shown in Fig. 1(a) and Fig. 1(b).

The nitride layer 13 refers to a layer of a hard nitride compound formed by nitriding a metal surface by nitrogen ion implantation. The nitrogen ion implantation will be specifically described in the description below of a method of producing a die for extrusion molding according to the present embodiment.

The nitride layer 13 has a hardness of preferably 1200 to 3000 Hv, and more preferably 2000 to 2500 Hv. The hardness refers to a Vickers hardness measured in accordance with JIS standard (Standard No. JIS Z 2244).

A Vickers hardness test is performed as follows. A needle-shaped object having a diamond-shaped tip (angle between faces: 136°), called a diamond indenter, is pressed at a test force F (kgf) to the surface of a substrate to be measured for the hardness. The surface area S (mm$^2$) of a resulting impression is calculated from the length d (average of the two-direction diagonal lines) of the diagonal lines. The hardness can be calculated from the length d, the surface area S, and the test force F (kgf) based on the following formula.

$$\text{Hardness (Hv)} = F\ (\text{kgf})/S\ (\text{mm}^2) = 0.1892F\ (\text{kgf})/d^2\ (\text{mm}^2)$$

The nitride layer 13 has a thickness (the length indicated by the double-headed arrow "d" in Fig. 1(b)) of preferably 5 to 1000 nm, and more preferably 10 to 100 nm.

Preferably, the nitride layer 13 having a uniform thickness is formed over the entire surfaces of the slit grooves 12.

The thickness of the nitride layer 13 can be measured, for example, using a secondary ion mass spectrometer (SIMS).

The secondary ion mass spectrometry is a method for determining the elements existing on the surface of a sample by sputtering the surface of the sample with a primary ion and then analyzing the mass of a secondary ion released from the surface of the sample into a vacuum upon the sputtering. The surface of the sample is chipped off by the sputtering, which enables elemental analysis in the depth direction.

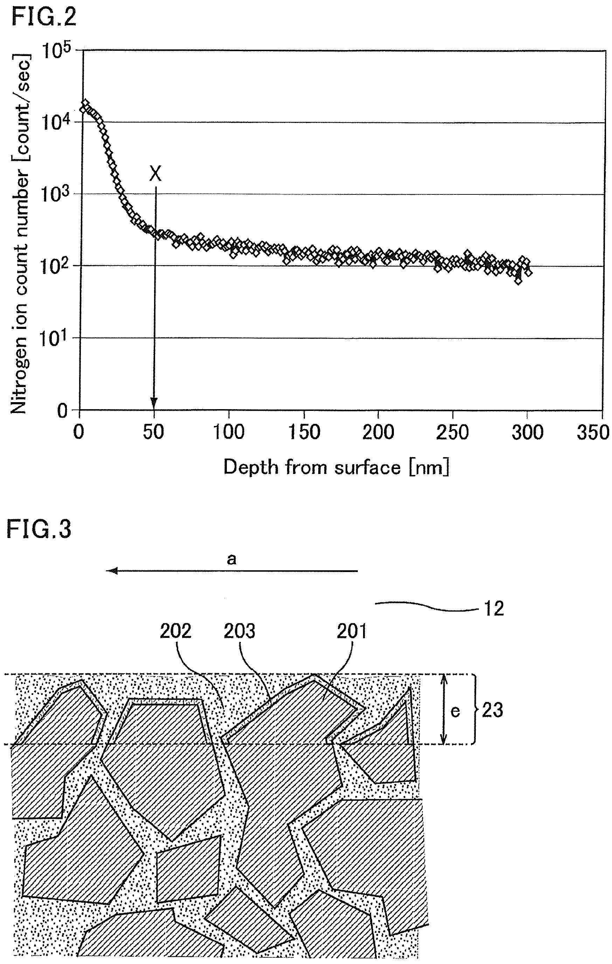

Fig. 2 is a graph showing one example of the results of a secondary ion mass spectrometry on the surface of the slit groove of the die for extrusion molding according to the first embodiment of the present invention.

The conditions for the analysis are a primary ion species of Cs+ion and a primary ion acceleration voltage of 3.0 kV.

In Fig. 2, the horizontal axis indicates the depth from the surface of the slit groove; and the vertical axis indicates the count number of nitrogen ions (secondary ions) released from the surface of the slit groove. In this example, the depth of a site X from the surface of the slit groove is considered as the thickness of the nitride layer provided on the surface of the slit groove. The site X was a site where almost no change was found in the number of nitrogen ions released from the surface of the slit groove.

The die for extrusion molding 100 is preferably made of a superhard alloy that includes a sintered mixture of tungsten carbide and cobalt, a superhard alloy that includes a sintered mixture of tungsten carbide, cobalt, and a trace amount of other particles (for example, TiC, TiN), tool steel, stainless steel, an aluminum alloy, or the like, and more preferably a superhard alloy that includes a sintered mixture of tungsten carbide and cobalt.

A superhard alloy that includes a sintered mixture of tungsten carbide and cobalt usually has a hardness of 1000 to 1500 Hv.

Fig. 3 is a cross-sectional view schematically illustrating slit grooves when the die for extrusion molding according to the first embodiment of the present invention is made of a superhard alloy.

Fig. 3 is a cross-sectional view of a slit groove illustrated in a direction parallel to the direction of extruding a molding raw material. The arrow "a" in Fig. 3 indicates the direction of extruding a molding raw material.

As shown in Fig. 3, the superhard alloy used as the material of the die for extrusion molding includes tungsten carbide particles 201 which are bonded by cobalt 202 mixed as a binder.

The tungsten carbide particles 201 preferably have an average particle size of 0.1 to 10 $\mu$m. The cobalt 202 content is preferably 3 to 20%.

Moreover, as shown in Fig. 3, the surfaces of the tungsten carbide particles 201 are nitrided so that a tungsten carbonitride 203 is formed in the vicinity of the surfaces of the slit grooves 12.

A nitride layer 23 shown in Fig. 3 corresponds to a layer of the tungsten carbonitride 203 formed on the surfaces of the tungsten carbide particles 201, and the nitride layer 23 corresponds to the nitride layer 13 shown in Fig. 1 (a) and Fig. 1 (b). The thickness (the length indicated by the double-headed arrow "e" in Fig. 3) of the nitride layer 23 shown in Fig. 3 corresponds to the thickness (the length indicated by the double-headed arrow "d" in Fig. 1(b)) of the nitride layer 13 shown in Fig. 1(b).

As mentioned earlier, the nitride layer 23 has a thickness (the length indicated by the double-headed arrow "e" in Fig. 3) of preferably 5 to 1000 nm, and more preferably 10 to 100 nm. In other words, the thickness of the nitride layer 23 is much smaller than the average particle size of the tungsten carbide particles 201. Thus, as shown in Fig. 3, the tungsten carbonitride 203 is preferably formed not on the entire surfaces of the tungsten carbide particles 201 but on the surfaces of the tungsten carbide particles 201 only in the vicinity of the surfaces of the slit grooves 12.

The length of the raw material supply section 11 in a direction parallel to the direction of extruding a molding raw material is preferably, but not limited to, 3 to 20 mm.

If the length of the raw material supply section 11 in a direction parallel to the direction of extruding a molding raw material is within the above range, a molding raw material can be readily extrusion molded.

The width (the length indicated by the double-headed arrow "b" in Fig. 1(b)) of the raw material supply section 11 is preferably, but not limited to, 1.0 to 1.5 mm.

If the width of the raw material supply section 11 is within the above range, a molding raw material can be readily extrusion molded.

In the case of the raw material supply section 11 having a round cross section, the width of the raw material supply section 11 refers to the diameter of the round. In the case of the raw material supply section 11 having a polygonal cross section, the width refers to the diameter of a hypothetical circumscribed round touching the vertices of the polygon.

As shown in Fig. 1(b), the raw material supply section 11 further includes a first opening 112 formed at the first face 10a, and a second opening 113 formed at a part where the second through hole 121 communicates with the first through hole 111. The width (the length indicated by the double-headed arrow "b" in Fig. 1(b)) of the raw material supply section 11 decreases from the first opening 112 toward the second opening 113.

The slit grooves 12 each has a slit width (the length indicated by the double-headed arrow "c" in Fig. 1(b)) that corresponds to the thickness of each cell wall or the thickness of the outer peripheral wall of the honeycomb molded body. The slit width is preferably 30 to 1000 $\mu$m, and more preferably 60 to 500 $\mu$m.

The length of the slit grooves 12 in a direction parallel to the direction of extruding a molding raw material is preferably, but not limited to, 1 to 4 mm.

If the length of the slit grooves 12 in a direction parallel to the direction of extruding a molding raw material is within the above range, a molding raw material can be readily extrusion molded.

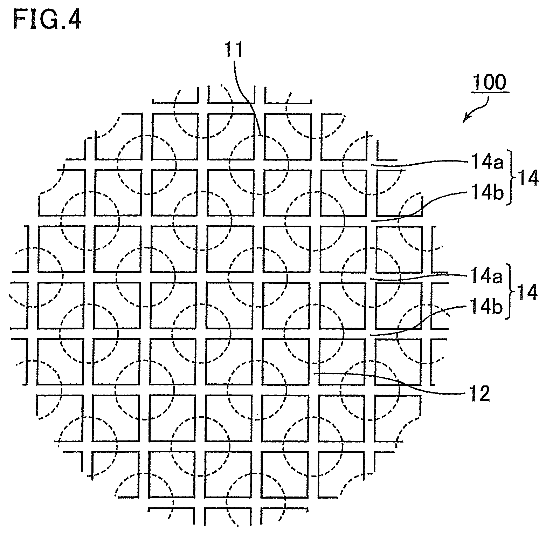

Fig. 4 is an enlarged front view of the die for extrusion molding shown in Fig. 1(a).

As shown in Fig. 4, the slit grooves 12 communicate with the raw material supply sections 11 and form a lattice pattern.

Supposing that points at which the slit grooves 12 intersect are intersections 14, the number of the intersections 14 is preferably 100 to 500 per square inch, and more preferably 200 to 400 per square inch.

Each of the raw material supply sections 11 is usually disposed at an intersection of the slit grooves 12.

Specifically, as shown in Fig. 4, supposing that adjacent ones among the intersections of the slit grooves 12 are intersections 14a and 14b, one of the raw material supply sections 11 is disposed on the intersection 14a.

The molding raw material may be selected depending on the materials of a honeycomb molded body (honeycomb structured body) to be produced.

Examples of the molding raw material include: nitride ceramics, such as aluminum nitride, silicon nitride, boron nitride, or titanium nitride; carbide ceramics, such as silicon carbide, zirconium carbide, titanium carbide, tantalum carbide, or tungsten carbide; and oxide ceramics, such as alumina, zirconia, cordierite, mullite, silica, or aluminum titanate. Silicon carbide is especially preferable.

The following describes a method of producing a die for extrusion molding according to the present embodiment.

The method of producing a die for extrusion molding according to the present embodiment is a method of producing a die for extrusion molding, the die including: a first face; a second face formed opposite the first face; a raw material supply section with a first through hole that extends from the first face toward the second face; and a molding section with a second through hole that extends from the second face toward the first face so as to communicate with the first through hole, the method including the steps of: machining a material of the die to form the material into a predetermined shape and to form a machining-affected layer on the inner wall surface of the second through hole in the molding section; forming an oxidized layer by heating the machining-affected layer to oxidize the layer so as to convert the machining-affected layer into an oxidized layer; removing the oxidized layer so that a treated surface is formed; and nitriding the treated surface by ion implantation to form a nitride layer.

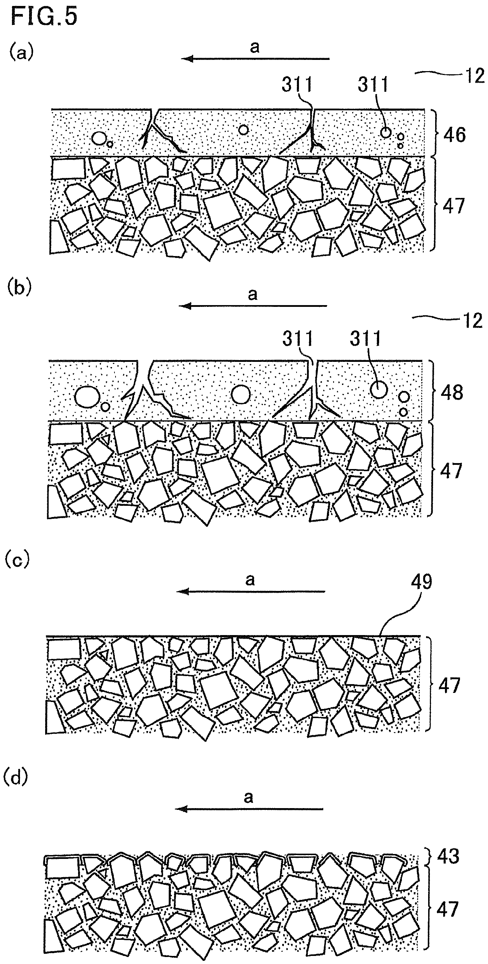

Figs. 5(a) to 5(d) are each a cross-sectional view schematically showing a method of producing a die for extrusion molding according to the first embodiment of the present invention. Fig. 5(a) to Fig. 5(d) are cross-sectional views of a die for extrusion molding illustrated in a direction parallel to the direction of extruding a molding raw material. The arrow "a" in Fig. 5 (a) to Fig. 5(d) indicates the direction of extruding a molding raw material.

First, a machining step is performed for machining a material of a die to form the material into a predetermined shape.

Specifically, as shown in Fig. 1(a) and Fig. 1(b), a material of the die is machined to form the first through hole 111 that extends from the first face 10a toward the second face 10b and then form the second through hole 121 that extends from the second face 10b toward the first face 10a so as to communicate with the first through hole 111. The molding section 12 includes slit grooves that communicate with a plurality of the second through holes 121, the slit grooves connecting to one another to form a lattice pattern.

In the following description, the inner wall surfaces of the second through holes 12 in the molding section 12 correspond to the surfaces of the slit grooves 12.

The shapes of the raw material supply sections 11 and the slit grooves 12 are described above, and thus the specific description thereof is omitted.

Examples of the methods for forming the raw material supply sections and the slit grooves include, but not particularly limited to, machining with a cutting tool, such as a drill.

If the die is made of a hard material, such as a superhard alloy, or a die to be produced has a complex shape, examples of the methods include electrical discharge machining. Electrical discharge machining is a method of applying voltages between a workpiece and the tool electrode to generate electric discharges, and gradually removing the workpiece by the spark energy of the electric discharge. The following three types of electrical discharge machining are known: die-sinking electrical discharge machining that includes transfer machining of a workpiece by use of a shaped electrode; wire electrical discharge machining that includes cutting a workpiece into a desired shape by use of a thin wire electrode; and small hole electrical discharge machining which enables formation of holes having a very small diameter by use of a rod electrode. Die-sinking electrical discharge machining is especially preferred.

The machining-affected layer 46 is formed on the surfaces of the slit grooves 12 through the machining step as shown in Fig. 5(a). The machining-affected layer 46 has defects 311, such as cracks and fine pores. A normal layer 47 having no defects, such as cracks and fine pores, exists beneath the machining-affected layer 46.

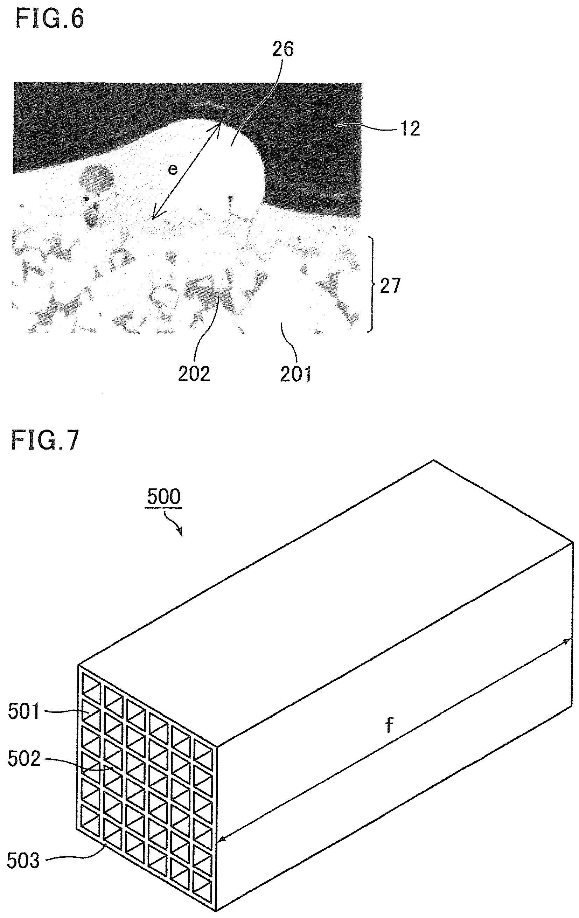

Fig. 6 is an SEM image of a cross-section of a surface of a slit groove after the machining step in the method of producing a die for extrusion molding according to the first embodiment of the present invention.

The die for extrusion molding shown in Fig. 6 is made of a superhard alloy that includes a sintered mixture of tungsten carbide and cobalt. The slit groove is formed by electrical discharge machining.

The machining-affected layer will be described in detail below with reference to Fig. 6.

As shown in Fig. 6, after the machining step, a machining-affected layer 26 is formed on the surfaces of the slit grooves 12.

The machining-affected layer 26 shown in Fig. 6 corresponds to the machining-affected layer 46 shown in Fig. 5(a).

The machining-affected layer 26 is a layer of melted and sintered tungsten carbide and cobalt, which are the materials of the die. The layer has defects, such as cracks and fine pores, caused by the thermal energy during the electrical discharge machining.

A normal layer 27 including tungsten carbide particles 201 and cobalt 202 as a binder exists beneath the machining-affected layer 26.

The machining-affected layer 26 preferably has a thickness (the length indicated by the double-headed arrow "e" in Fig. 6) of 0.1 to 20 $\mu$m.

The thickness of the machining-affected layer can be measured based on an SEM image. The minimum value of the above range is an average of the thickness of any 10 sites where the thickness of the machining-affected layer 26 is apparently small. The maximum value of the above range is an average of the thickness of any 10 sites where the thickness of the machining-affected layer 26 is apparently large.

Next, the step of forming an oxidized layer is performed by heating the machining-affected layer to oxidize the layer so as to convert the machining-affected layer into an oxidized layer.

Specifically, the step is preferably performed by heating the machining-affected layer 46 to a temperature of 500 to 1000°C in an oxygen atmosphere. The step is more preferably performed by heating the machining-affected layer 46 to a predetermined temperature of 500 to 1000°C in a nitrogen atmosphere; and then allowing the heated machining-affected layer to stand at the predetermined temperature in an oxygen atmosphere for 5 to 180 minutes.

Preferably, an electric furnace is used for the heating.

The machining-affected layer 46 is converted to an oxidized layer 48 through the step of forming an oxidized layer as shown in Fig. 5(b).

In the case, for example, where the machining-affected layer 46 is a layer including tungsten carbide (WC) and cobalt (Co), the oxidation converts the machining-affected layer 46 into the oxidized layer 48 including tungsten oxide ($WO_3$), an oxide ($CoWO_4$) of mixture of tungsten and cobalt, and cobalt oxide (CoO). The WC or Co increases its volume when it is oxidized to $WO_3$, $CoWO_4$, or CoO, which increases the defects 311, such as cracks and small pores. As a result, an oxidized layer with excellent peelability is formed.

Next, the step of removing the oxidized layer is performed.

The removal of the oxidized layer is preferably performed by flow polishing. Specifically, the flow polishing is performed by repeating a series of introducing an abrasive uniformly into the raw material supply sections and extruding the abrasive from the slit grooves.

The abrasive is preferably silicon carbide having a grain size from #100 to #1000, and especially preferably silicon carbide having a grain size #600 (average grain size: 25.8 $\mu$m).

The polishing is preferably performed under the condition of a polishing pressure of 1 to 10 MPa, a polishing temperature of 10 to 50°C, and a polishing time period of 5 to 48 hours. If the polishing pressure, the polishing temperature and the polishing time period are each within the above range, the oxidized layer is sufficiently removed so that a treated surface with a flat surface can be obtained.

The oxidized layer 48 is removed through the step of removing the oxidized layer as shown in Fig. 5(c) so that the treated surface 49 is obtained. The normal layer 47 having no defects, such as cracks and fine pores, exists beneath the treated surface 49.

The treated surface 49 preferably has a surface roughness (Ra) of 0.1 to 5.0 $\mu$m.

The surface roughness (Ra) refers to a center-line average roughness in accordance with JIS standard (Standard No. : JIS B 0601), and can be measured with, for example, a stylus type surface roughness tester.

The treated surface 49 has a hardness of preferably 300 to 1500 Hv. The hardness refers to a Vickers hardness measured in accordance with JIS standard (Standard No. JIS Z 2244).

Lastly, a nitriding step is performed for forming a nitride layer by nitrogen ion implantation on the treated surface.

The nitrogen ion implantation herein means a method of applying a negative pulse voltage to a workpiece placed in plasma so as to implant nitrogen ions into the workpiece, so that a nitride layer is formed.

First, a high-frequency power is applied between a device and the die to generate plasma.

Preferably, the output and frequency of the high-frequency power are 0.3 to 2.0 kW and 13.56 MHz, respectively. Preferably, the application time is 100 to 500 $\mu$sec, and a downtime is 50 to 300 $\mu$sec.

Then, a negative high voltage pulse is applied to the die housed in the device in which plasma is generated.

The nitrogen ions in the plasma are accelerated toward the surface of the die so that the nitrogen ions are implanted into the die through the surface. Metals in the vicinity of the surface of the die react with the nitrogen ions and are nitrided to form a nitride layer.

The voltage of the high voltage pulse is preferably -5 to -20 kV. The thickness of a nitride layer can be changed by changing the voltage of the high voltage pulse.

For example, in the case of using a superhard alloy including a sintered mixture of tungsten carbide (WC) and cobalt as the material of the die, the tungsten carbide (WC) reacts with nitrogen ions so that a nitride layer including tungsten carbonitride (WCN) is formed.

The die for extrusion molding according to the present embodiment can be produced through the above steps.

The nitriding step of forming the nitride layer 13 by the nitrogen ion implantation on the surfaces of the slit grooves 12 preferably enhances the hardness of the surfaces of the slit grooves 12 by 1.2 to 2 times.

Through the nitriding step, a nitride layer 43 is formed on the treated surface 49 as shown in Fig. 5(d). The nitride layer is already described, and thus the detailed description thereof is omitted.

Through the above steps, a die for extrusion molding according to the present embodiment can be produced.

Lastly, the following describes one example of a method of producing a honeycomb structured body using the die for extrusion molding according to the present embodiment.

The method of producing a honeycomb structured body according to the present embodiment includes the steps of: extrusion molding a molding raw material through a die for extrusion molding to produce at least one honeycomb molded body that includes a large number of cells, the cells being separated by cell walls and arranged in parallel with one another in a longitudinal direction; firing the at least one honeycomb molded body to produce at least one honeycomb fired body; and producing a ceramic block of the at least one honeycomb fired body, the die including: a first face; a second face formed opposite the first face; a raw material supply section with a first through hole that extends from the first face toward the second face; and a molding section with a second through hole that extends from the second face toward the first face so as to communicate with the first through hole, wherein the die is obtainable through the steps of: machining a material of the die to form the material into a predetermined shape and to form a machining-affected layer on the inner wall surface of the second through hole in the molding section; forming an oxidized layer by heating the machining-affected layer to oxidize the layer so as to convert the machining-affected layer into an oxidized layer; removing the oxidized layer so that a treated surface is formed; and nitriding the treated surface by ion implantation to form a nitride layer.

(1) First, a wet mixture (molding raw material) of ceramic powders and a binder is prepared.

Specifically, ceramic powders, an organic binder, a liquid plasticizer, a lubricant, and water are mixed to prepare a wet mixture for producing a honeycomb molded body.

The ceramic powders may be selected depending on the materials of a honeycomb molded body (honeycomb structured body) to be produced.

Examples of the main component of the materials of the honeycomb molded body include nitride ceramics, such as aluminum nitride, silicon nitride, boron nitride, or titanium nitride; carbide ceramics, such as silicon carbide, zirconium carbide, titanium carbide, tantalum carbide, or tungsten carbide; and oxide ceramics, such as alumina, zirconia, cordierite, mullite, silica, or aluminum titanate.

The main component of the materials of the honeycomb molded body is preferably a non-oxide ceramic, and particularly preferably silicon carbide because such materials have excellent heat resistance, mechanical strength, thermal conductivity, or the like.

Herein, the expression "the main component is silicon carbide" means that the silicon carbide content in the ceramic powders is not less than 60% by weight. In the case where the main component is silicon carbide, the main component may also include silicon-bonded silicon carbide. The same is true to the case where the main component is a component of the materials other than silicon carbide.

(2) Next, the wet mixture (molding raw material) is extrusion molded into a honeycomb molded body having a predetermined shape.

The die for extrusion molding according to the present embodiment is used for the extrusion molding.

Fig. 7 is a perspective view schematically illustrating one example of a honeycomb molded body that is extrusion molded through the die for extrusion molding according to the first embodiment of the present invention. A honeycomb molded body 500 shown in Fig. 7 includes a large number of cells 501 that are separated by cell walls 502 and arranged in parallel with one another in a longitudinal direction (the direction of the double-headed arrow "f" in Fig. 7). An outer peripheral wall 503 is formed on the circumference of the cells 501 and the cell walls 502.

(3) Thereafter, the honeycomb molded body is dried using a drier, such as a microwave drier, a hot air drier, a dielectric drier, a reduced pressure drier, a vacuum drier, or a freeze drier, to thereby produce a dried honeycomb dried body.

The dried honeycomb molded body is degreased (for example, at 200 to 500°C) and fired (for example, at 1400 to 2300°C) under predetermined conditions.

Through the above steps, a honeycomb fired body including: a large number of cells that are separated by cell walls and arranged in parallel with one another in a longitudinal direction; and an outer peripheral wall provided on the circumference thereof can be produced.

The degreasing and firing of the dried honeycomb molded body may be performed under conventional conditions for producing honeycomb fired bodies.

The method of producing a honeycomb structured body using the die for extrusion molding according to the present embodiment enables production of a honeycomb fired body in which one of end portions of each cell is plugged. In this case, after the drying in the step (3), predetermined end portions of the cells of the dried honeycomb molded body are filled with a predetermined amount of a plug material paste, which becomes a plug, to plug the cells. Then, the honeycomb molded body is degreased and fired as described above so that a honeycomb fired body in which one of end portions of each cell is plugged can be produced.

The wet mixture may be used as the plug material paste.

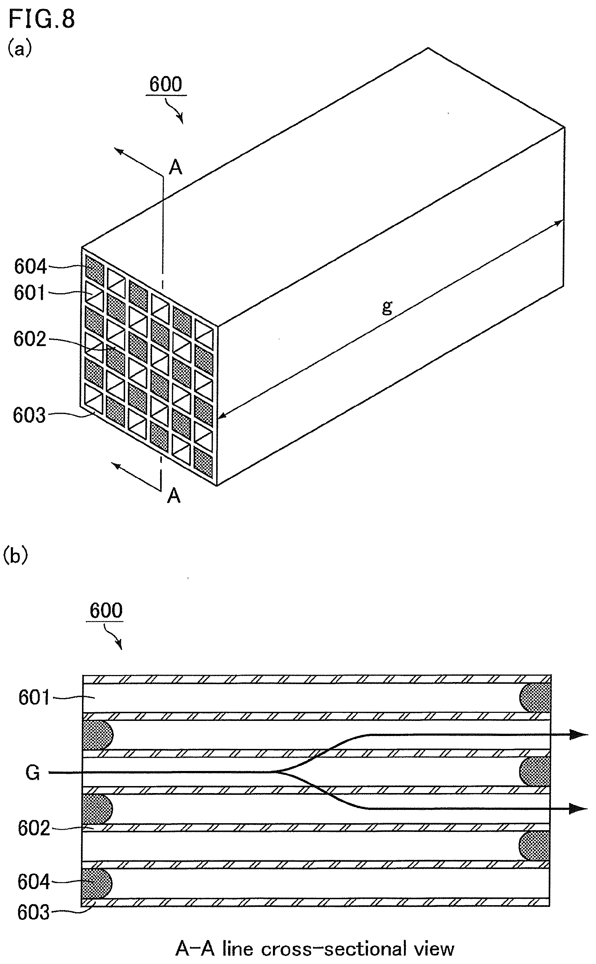

Fig. 8(a) is a perspective view schematically illustrating one example of a honeycomb fired body that is produced using the die for extrusion molding according to the present embodiment. Fig. 8(b) is an A-A line cross-sectional view of the honeycomb fired body shown in Fig. 8(a).

A honeycomb fired body 600 shown in Fig. 8(a) and Fig. 8(b) includes: a large number of cells 601 that are separated by cell walls 602 and arranged in parallel with one another in a longitudinal direction (the direction of an arrow "g" in Fig. 8(a)); and an outer peripheral wall 603 provided on the circumference of the cells 601 and the cell walls 602. One of the end portions of each cell 601 is plugged with a plug 604.

Thus, exhaust gas G (exhaust gas is indicated by G, and the flow of the exhaust gas is indicated by an arrow in Fig. 8 (b)) which enters one of the cells 601 with one end opened will always pass through the cell wall 602 separating the cells 601 to flow out from another one of the cells 601 with an another end opened. PMs or the like in exhaust gas are captured when the exhaust gas G passes through the cell walls 602. The cell walls 602 thus function as a filter.

As mentioned earlier, a honeycomb structured body including the honeycomb fired body in which one of the end portions of each cell is plugged can be favorably used as a ceramic filter. Furthermore, a honeycomb structured body including a honeycomb fired body in which none of the end portions of the cells is plugged can be favorably used as a catalyst carrier.

(4) Next, a ceramic block of at least one honeycomb fired body is produced.

The following describes one example of a method of producing a ceramic block of a plurality of honeycomb fired bodies which are combined with adhesive layers.

First, an adhesive paste, which becomes an adhesive layer, is applied to a predetermined side face of one of the honeycomb fired bodies to form an adhesive paste layer. Another honeycomb fired body is then stacked on the adhesive paste layer. Through repetition of this process, an aggregate of the honeycomb fired bodies is produced.

Next, the aggregate of the honeycomb fired bodies is heated to dry and solidify the adhesive paste layers so that a ceramic block is produced.

The adhesive paste is, for example, one including an inorganic binder, an organic binder, and inorganic particles. The adhesive paste may also include inorganic fibers and/or a whisker.

(5) Thereafter, a ceramic block is machined.

Specifically, the outer periphery of the ceramic block is machined with a cutter, such as a diamond cutter, to produce a ceramic block with a round pillar-shaped outer periphery.

(6) Next, an outer periphery coating material paste is applied to an outer peripheral surface of the round pillar-shaped ceramic block, and is then solidified by drying to form an outer periphery coat layer.

The adhesive paste may be used as the outer periphery coating material paste. The outer periphery coating material paste may be a paste having different composition from that of the adhesive paste.

The outer periphery coat layer is not essential, but may be provided as needed.

Through the above steps, a honeycomb structured body can be produced.

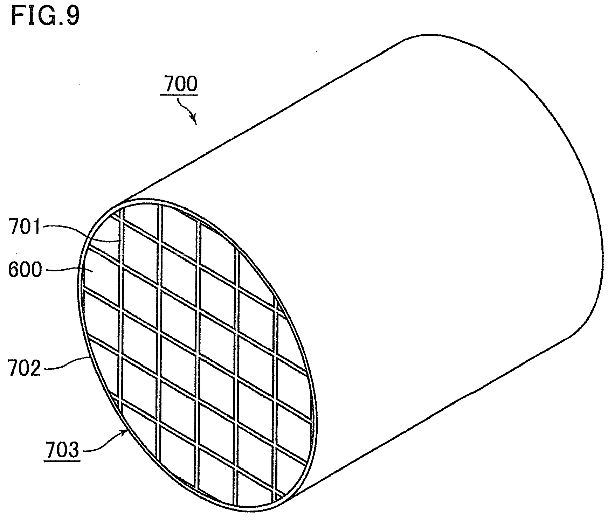

Fig. 9 is a perspective view schematically illustrating one example of a honeycomb structured body that is produced using the die for extrusion molding according to the present embodiment.

A honeycomb structured body 700 shown in Fig. 9 includes a ceramic block 703 and an outer periphery coat layer 702 formed on an outer periphery of the ceramic block 703. The ceramic block includes a plurality of honeycomb fired bodies 600 which are combined with one another with adhesive layers 701 provided therebetween. The outer periphery coat layer may be formed as needed.

The honeycomb structured body including a plurality of honeycomb fired bodies combined is also referred to as an aggregated honeycomb structured body.

The effects of the die for extrusion molding and the method of producing a die for extrusion molding according to the present embodiment are listed below.

(1) The die for extrusion molding according to the present embodiment is provided through the steps of forming an oxidized layer by heating the machining-affected layer to oxidize the layer so as to convert the machining-affected layer into an oxidized layer; removing the oxidized layer so that a treated surface is formed, and nitriding the treated surface by ion implantation to form a nitride layer. A less fragile treated surface is provided on the surfaces of the slit grooves when the treated surface is formed through the steps of forming an oxidized layer and removing the oxidized layer. Moreover, the nitride layer that is formed on the treated surface through the nitriding step further increases the hardness of the surfaces of the slit grooves. The surfaces of the slit grooves are less likely to be worn away even after repeated extrusion molding of molding raw materials. Thus, the life of the die can be increased.

(2) In a die for extrusion molding according to the present embodiment, the nitride layer has a thickness of 5 to 1000 nm.

If the nitride layer has a thickness within the above range, the surfaces of the slit grooves can long maintain the abrasion resistance in the molding section. Thus, the life of the die can be further increased.

(3) In a die for extrusion molding according to the present embodiment, the nitride layer has a hardness of 1200 to 3000 Hv. If the nitride layer has a hardness within the above range, the surfaces of the slit grooves are less likely to be worn away even after repeated extrusion molding of molding raw materials. Thus, the life of the die can be further increased.

(4) The die for extrusion molding according to the present embodiment is made of a superhard alloy that includes a sintered mixture of tungsten carbide and cobalt, and the nitride layer includes tungsten carbonitride. If the die for extrusion molding is made of the above materials, the surfaces of the slit grooves have higher hardness. Thus, the surfaces of the slit grooves are less likely to be worn away. As a result, the life of the die can be further increased.

(5) In the die for extrusion molding according to the present embodiment, the step of removing the oxidized layer is performed by flow polishing. The flow polishing enables a treated surface where the oxidized layer is sufficiently removed. Such a treated surface is less fragile than the machining-affected layer. The surfaces of the slit grooves where a nitride layer is formed on the treated surface is much less likely to be worn away even after repeated extrusion molding of molding raw materials. Thus, the life of the die can be further increased.

(6) In the die for extrusion molding according to the present embodiment, the molding raw material to be supplied to the raw material supply section includes silicon carbide. Even if the molding raw material includes silicon carbide, which is very hard, the surfaces of the slit grooves are less likely to be worn away. Thus, the life of the die can be increased.

(7) In the die for extrusion molding according to the present embodiment, the raw material supply section further includes a first opening formed at the first face and a second opening formed at a part where the second through hole communicates with the first through hole. Also, the width of the raw material supply section decreases from the first opening toward the second opening.

If the width of the raw material supply section decreases from the first opening toward the second opening, a molding raw material readily flows from the raw material supply section to the molding section. Thus, the molding raw material is prevented from clogging in the die for extrusion molding.

(8) The method of producing a die for extrusion molding according to the present embodiment includes the steps of: forming an oxidized layer by heating the machining-affected layer to oxidize the layer so as to convert the machining-affected layer into an oxidized layer; and removing the oxidized layer so that a treated surface is formed. In the step of forming an oxidized layer, the machining-affected layer is heated so that the machining-affected layer is gradually oxidized from the surface to the inside. As a result, an oxidized layer with excellent peelability is formed. Thus, in the step of removing the oxidized layer, the oxidized layer can be readily removed to obtain a treated surface. Moreover, the method of producing a die for extrusion molding according to the present embodiment includes a nitriding step to form a nitride layer by nitrogen ion implantation on the treated surface. A uniform nitride layer can be formed in the nitriding step. In particular, even if the machined die has a complex shape, the nitride layer can be uniformly formed. Formation of the uniform nitride layer enables favorable production of the die for extrusion molding according to the present embodiment.

(9) In the method of producing a die for extrusion molding according to the present embodiment, the machining step is performed by die-sinking electrical discharge machining. If the machining step is performed by die-sinking electrical discharge machining, the material of the die, even if it is a hard material, can be favorably machined into a predetermined shape. Moreover, if the machining step is performed by die-sinking electrical discharge machining, the material can be favorably machined into the shape of the die to be produced even if the shape is complex.

(10) In the method of producing a die for extrusion molding according to the present embodiment, in the step of forming an oxidized layer, the machining-affected layer is heated to a temperature of 500 to 1000°C in an oxygen atmosphere. Heating the machining-affected layer to a temperature within the above range in an oxygen atmosphere can sufficiently oxidize the machining-affected layer.

(11) In the method of producing a die for extrusion molding according to the present embodiment, in the step of forming an oxidized layer, the machining-affected layer is heated to a predetermined temperature of 500 to 1000°C in a nitrogen atmosphere; and the heated machining-affected layer is left stand at the predetermined temperature in an oxygen atmosphere for 5 to 180 minutes. Dies for extrusion molding used to produce honeycomb molded bodies need to have high dimensional accuracy. In the step of forming an oxidized layer, the oxidation includes introduction of oxygen after the heating and then maintenance of a given temperature. Thus, the oxygen concentration can be controlled during the oxidation. As a result, an oxidized layer with a uniform thickness can be formed, which in turn can produce a die with a high dimensional accuracy.

(12) In the method of producing a die for extrusion molding according to the present embodiment, the step of removing the oxidized layer is performed by flow polishing. The flow polishing enables easy removal of the oxidized layer.

EXAMPLES

The following examples more specifically describe the present embodiment. The present invention is not limited to the examples.

Example 1 more specifically describes the first embodiment of the present invention.

(Example 1)

A superhard alloy that includes a sintered mixture of tungsten carbide and cobalt was prepared as a material of a die. The material of a die had a hardness of 1200 Hv.

The material of a die was subjected to die-sinking electrical discharge machining so as to form the material into the shape shown in Fig. 1 (a). Specifically, the outer periphery was machined to form a protruded second face where a second through hole was to be formed. Then, a first through hole having a round cross section was formed from the first face toward the second face. Next, the second through hole was formed from the second face toward the first face so as to communicate with the first through hole.

An electrical discharge machining sinker (EA8PV, produced by Mitsubishi Electric Corporation) was used for the die-sinking electrical discharge machining under a peak current of 5 to 20A.

A machining-affected layer was formed on the surfaces of the slit grooves by the machining.

Next, the machining-affected layer was oxidized by heating so as to convert the machining-affected layer into an oxidized layer.

The machining-affected layer was oxidized by firstly heating the machining-affected layer from room temperature to 700°C over one hour in a nitrogen atmosphere, and then keeping the temperature for 105 minutes in an oxygen atmosphere (oxygen concentration: 20.8%). Thereafter, the temperature was decreased to room temperature in a nitrogen atmosphere. An electric furnace was used for the heating.

Next, the oxidized layer was removed so that a treated surface was formed.

The oxidized layer was removed by flow polishing. The flow polishing was performed by repeating a series of introducing an abrasive uniformly into the raw material supply sections and extruding the abrasive from the slit grooves. The abrasive used was silicon carbide having a grain size #600 (average grain size: 25.8 $\mu$m). The polishing pressure was 6 MPa, the polishing temperature was 30°C, and the polishing time period was 24 hours.

The removal of the oxidized layer was checked by observing a cross-section of the surfaces of the slit grooves using a microscope (VHK-100, produced by KEYENCE CORPORATION).

Lastly, a high voltage pulse of -18 kV was applied for 60 minutes to a die housed in a device in which plasma was generated to thereby form a nitride layer on the treated surface.

A die for extrusion molding was produced through the above steps.

The surfaces of the slit grooves have a higher hardness in the die for extrusion molding produced as above in Example 1. The surfaces of the slit grooves are considered less likely to be worn away even after repeated extrusion molding of molding raw materials. Thus, the life of the die can be increased.

(Other embodiments)

The honeycomb structured body produced using the die for extrusion molding according to the first embodiment of the present invention is an aggregated honeycomb structured body but may be a honeycomb structured body (integrated honeycomb structured body) including a single honeycomb fired body.

For producing an integrated honeycomb structured body, a honeycomb molded body is produced in the same manner as in the first embodiment of the present invention, except that a honeycomb molded body to be extrusion molded is larger than and has a different profile from the honeycomb molded body described in the first embodiment of the present invention.

In other words, the honeycomb molded body may be produced using a die for extrusion molding that has the same structure as that of the die for extrusion molding according to the first embodiment of the present invention, and has a cross-sectional shape corresponding to the shape of the honeycomb molded body to be obtained.

The other steps are the same as those described in the method of producing a honeycomb structured body according to the first embodiment of the present invention. Since the honeycomb structured body includes a single honeycomb fired body, production of an aggregate of the honeycomb fired bodies is not necessary. In the case of producing a round pillar-shaped honeycomb molded body, machining of the outer periphery of the ceramic block is not necessary.

In the die for extrusion molding according to the embodiments of the present invention, the raw material supply section in the die may have any shape. Examples of the cross-sectional shape of the raw material supply section parallel to the direction of extruding a molding raw material include a rectangular shape, a tapered shape, and a trapezoidal shape.

A tapered cross-sectional shape is especially preferable for easy extrusion of a molding raw material.

Similarly, in the die for extrusion molding according to the embodiments of the present invention, the slit groove of the die may have any shape. Examples of the cross-sectional shape of the slit groove parallel to the direction of extruding a molding raw material include a rectangular shape and a tapered shape.

A rectangular cross-sectional shape is especially preferable for easy formation of the slit grooves.

The essential feature of the die for extrusion molding of the present invention is that the die includes: a first face; a second face formed opposite the first face; a raw material supply section with a first through hole that extends from the first face toward the second face; and a molding section with a second through hole that extends from the second face toward the first face so as to communicate with the first through hole, wherein the die is obtainable through the steps of: machining a material of the die to form the material into a predetermined shape and to form a machining-affected layer on the inner wall surface of the second through hole in the molding section; forming an oxidized layer by heating the machining-affected layer to oxidize the layer so as to convert the machining-affected layer into an oxidized layer; removing the oxidized layer so that a treated surface is formed; and nitriding the treated surface by ion implantation to form a nitride layer.

The essential feature of the method of producing a die for extrusion molding of the present invention is that the die includes: a first face; a second face formed opposite the first face; a raw material supply section with a first through hole that extends from the first face toward the second face; and a molding section with a second through hole that extends from the second face toward the first face so as to communicate with the first through hole, the method including the steps of: machining a material of the die to form the material into a predetermined shape and to form a machining-affected layer on the inner wall surface of the second through hole in the molding section; forming an oxidized layer by heating the machining-affected layer to oxidize the layer so as to convert the machining-affected layer into an oxidized layer, removing the oxidized layer so that a treated surface is formed, and nitriding the treated surface by ion implantation to form a nitride layer.

The essential feature of the method of producing a honeycomb structured body of the present invention is that the method includes the steps of: extrusion molding a molding raw material through a die for extrusion molding to produce at least one honeycomb molded body that includes a large number of cells, the cells being separated by cell walls and arranged in parallel with one another in a longitudinal direction; firing the at least one honeycomb molded body to produce at least one honeycomb fired body; and producing a ceramic block of the at least one honeycomb fired body, the die including: a first face; a second face formed opposite the first face; a raw material supply section with a first through hole that extends from the first face toward the second face; and a molding section with a second through hole that extends from the second face toward the first face so as to communicate with the first through hole, wherein the die is obtainable through the steps of: machining a material of the die to form the material into a predetermined shape and to form a machining-affected layer on the inner wall surface of the second through hole in the molding section; forming an oxidized layer by heating the machining-affected layer to oxidize the layer so as to convert the machining-affected layer into an oxidized layer; removing the oxidized layer so that a treated surface is formed; and nitriding the treated surface by ion implantation to form a nitride layer.

Desired effects can be obtained by appropriately combining the essential features with the various structures (for example, the shape of the raw material supply sections, the shape of the slit grooves, or the like) mentioned in detail in the above description of the first embodiment of the present invention and other embodiments of the present invention.

REFERENCE SIGNS LIST

| | |
|---|---|
| 10a | First surface |
| 10b | Second surface |
| 11 | Raw material supply section |

| 12 | Molding section (slit groove) |
| 13, 23, 43 | Nitride layer |
| 26, 46 | Machining-affected layer |
| 48 | Oxidized layer |
| 49 | Treated surface |
| 100 | Die for extrusion molding |
| 111 | First through hole |
| 112 | First opening |
| 113 | Second opening |
| 121 | Second through hole |
| 500 | Honeycomb molded body |
| 501, 601 | Cell |
| 502, 602 | Cell wall |
| 600 | Honeycomb fired body |
| 700 | Honeycomb structured body |
| 703 | Ceramic block |

**Claims**

1. A die for extrusion molding comprising:

   a first face;
   a second face formed opposite the first face;
   a raw material supply section with a first through hole that extends from the first face toward the second face; and
   a molding section with a second through hole that extends from the second face toward the first face so as to communicate with the first through hole,

   wherein the die is obtainable through the steps of:

   machining a material of the die to form the material into a predetermined shape and to form a machining-affected layer on the inner wall surface of the second through hole in the molding section;
   forming an oxidized layer by heating the machining-affected layer to oxidize the layer so as to convert the machining-affected layer into the oxidized layer;
   removing the oxidized layer so that a treated surface is formed; and
   nitriding the treated surface by ion implantation to form a nitride layer.

2. The die according to claim 1,
   wherein the raw material supply section further comprises a first opening formed at the first face and a second opening formed at a part where the second through hole communicates with the first through hole, and
   the width of the raw material supply section decreases from the first opening toward the second opening.

3. The die according to claim 1 or 2,
   wherein the molding section comprises slit grooves that communicate with a plurality of the second through holes, the slit grooves connecting to one another to form a lattice pattern.

4. The die according to any one of claims 1 to 3, obtainable further through the steps of:

   machining a material of the die to form the material into a predetermined shape and to form a machining-affected layer on the inner wall surface of the first through hole in the raw material supply section;
   forming an oxidized layer by heating the machining-affected layer to oxidize the layer so as to convert the machining-affected layer into an oxidized layer;
   removing the oxidized layer so that a treated surface is formed; and
   nitriding the treated surface by ion implantation to form a nitride layer.

5. The die according to any one of claims 1 to 4,
   wherein the nitride layer has a thickness of 5 to 1000 nm.

6. The die according to any one of claims 1 to 5,
   wherein the nitride layer has a hardness of 1200 to 3000 Hv.

7. The die according to any one of claims 1 to 6,
   wherein the die is made of a superhard alloy that comprises a sintered mixture of tungsten carbide and cobalt, and the nitride layer comprises tungsten carbonitride.

8. The die according to any one of claims 1 to 7,
   wherein the step of removing the oxidized layer is performed by flow polishing.

9. The die according to any one of claims 1 to 8,
   wherein a molding raw material to be introduced to the raw material supply section comprises silicon carbide.

10. A method of producing a die for extrusion molding, the die comprising:

    a first face;
    a second face formed opposite the first face;
    a raw material supply section with a first through hole that extends from the first face toward the second face; and
    a molding section with a second through hole that extends from the second face toward the first face so as to communicate with the first through hole,

    the method comprising the steps of:

    machining a material of the die to form the material into a predetermined shape and to form a machining-affected layer on the inner wall surface of the second through hole in the molding section;
    forming an oxidized layer by heating the machining-affected layer to oxidize the layer so as to convert the machining-affected layer into an oxidized layer;
    removing the oxidized layer so that a treated surface is formed; and
    nitriding the treated surface by ion implantation to form a nitride layer

11. The method according to claim 10,
    wherein the machining step is performed by die-sinking electrical discharge machining.

12. The method according to claim 10 or 11,
    wherein, in the step of forming an oxidized layer, the machining-affected layer is heated to a temperature of 500 to 1000°C in an oxygen atmosphere.

13. The method according to claim 10 or 11,
    wherein, in the step of forming an oxidized layer, the machining-affected layer is heated to a predetermined temperature of 500 to 1000°C in a nitrogen atmosphere; and
    the heated machining-affected layer is left stand at the predetermined temperature in an oxygen atmosphere for 5 to 180 minutes.

14. The method according to any one of claims 10 to 13,
    wherein the step of removing the oxidized layer is performed by flow polishing.

15. A method of producing a honeycomb structured body comprising the steps of:
    extrusion molding a molding raw material through a die for extrusion molding to produce at least one honeycomb molded body that comprises a large number of cells, the cells being separated by cell walls and arranged in parallel with one another in a longitudinal direction;
    firing the at least one honeycomb molded body to produce at least one honeycomb fired body; and
    producing a ceramic block of the at least one honeycomb fired body,
    the die comprising:

    a first face;
    a second face formed opposite the first face;
    a raw material supply section with a first through hole that extends from the first face toward the second face; and
    a molding section with a second through hole that extends from the second face toward the first face so as to communicate with the first through hole,

wherein the die is obtainable through the steps of:

machining a material of the die to form the material into a predetermined shape and to form a machining-affected layer on the inner wall surface of the second through hole in the molding section;
forming an oxidized layer by heating the machining-affected layer to oxidize the layer so as to convert the machining-affected layer into an oxidized layer;
removing the oxidized layer so that a treated surface is formed; and
nitriding the treated surface by ion implantation to form a nitride layer

**Patentansprüche**

1.  Matrize zum Extrusionsformen, umfassend:

    eine erste Fläche;
    eine zweite Fläche, die gegenüber der ersten Fläche ausgebildet ist;
    einen Rohmaterial-Zufuhrabschnitt mit einer ersten Durchgangsöffnung, die sich von der ersten Fläche zur zweiten Fläche erstreckt; und
    einen Formabschnitt mit einer zweiten Durchgangsöffnung, die sich von der zweiten Fläche zur ersten Fläche erstreckt, um mit der zweiten Fläche in Verbindung zu stehen,

    wobei die Matrize durch folgende Schritte erhaltbar ist:

    Bearbeiten des Materials der Matrize zum Ausbilden des Materials in eine vorgegebene Form und zum Ausbilden einer der Bearbeitung unterzogenen Schicht auf der Innenwandfläche der zweiten Durchgangsöffnung im Formabschnitt;
    Ausbilden einer oxidierten Schicht durch Erhitzen der der Bearbeitung unterzogenen Schicht, um die Schicht zu oxidieren, um die der Bearbeitung unterzogene Schicht in die oxidierte Schicht umzuwandeln;
    Entfernen der oxidierten Schicht, sodass die behandelte Oberfläche ausgebildet wird; und
    Nitrieren der behandelten Oberfläche durch eine Ionenimplantation zum Ausbilden einer Nitridschicht.

2.  Matrize nach Anspruch 1,
    wobei der Rohmaterial-Zufuhrabschnitt ferner eine erste Öffnung, die in der ersten Fläche ausgebildet ist, und eine zweite Öffnung aufweist, die in einem Teil ausgebildet ist, wo die zweite Durchgangsöffnung mit der ersten Durchgangsöffnung verbunden ist, und
    die Breite des Rohmaterial-Zufuhrabschnitts von der ersten Öffnung zur zweiten Öffnung abnimmt.

3.  Matrize nach Anspruch 1 oder 2,
    wobei der Formabschnitt schlitzförmige Nuten aufweist, die mit einer Vielzahl der zweiten Durchgangsöffnungen verbunden sind, wobei die schlitzförmigen Nuten miteinander verbunden sind, um ein Gittermuster zu bilden.

4.  Matrize nach einem der Ansprüche 1 bis 3, die ferner durch folgende Schritte erhaltbar ist:

    Bearbeiten eines Materials der Matrize zum Ausbilden des Materials in eine vorgegebene Form und zum Ausbilden einer der Bearbeitung unterzogenen Schicht auf der Innenwandfläche der ersten Durchgangsöffnung im Rohmaterial-Zufuhrabschnitt;
    Ausbilden einer oxidierten Schicht durch Erhitzen der der Bearbeitung unterworfenen Schicht, um die Schicht zu oxidieren, um die der Bearbeitung unterzogene Schicht in eine oxidierte Schicht umzuwandeln;
    Entfernen der oxidierten Schicht, sodass die behandelte Oberfläche ausgebildet wird; und
    Nitrieren der behandelten Oberfläche durch eine Ionenimplantation zum Ausbilden einer Nitridschicht.

5.  Matrize nach einem der Ansprüche 1 bis 4,
    wobei die Nitridschicht eine Dicke von 5 bis 1000 nm aufweist.

6.  Matrize nach einem der Ansprüche 1 bis 5,
    wobei die Nitridschicht eine Härte von 1200 bis 3000 Hv aufweist.

**7.** Matrize nach einem der Ansprüche 1 bis 6,
wobei die Matrize aus einer superharten Legierung hergestellt ist, die eine gesinterte Mischung aus Wolframkarbid und Kobalt aufweist, und
die Nitridschicht Wolfram-Carbonitrit aufweist

**8.** Matrize nach einem der Ansprüche 1 bis 7,
wobei der Schritt des Entfernens der oxidierten Schicht durch Strahl-Polieren (Flow-Polishing) ausgeführt wird.

**9.** Matrize nach einem der Ansprüche 1 bis 8,
wobei ein Form-Rohmaterial, das dem Rohmaterial-Zufuhrabschnitt zugeführt werden soll, Siliziumkarbid aufweist.

**10.** Verfahren zum Herstellen einer Matrize zum Extrusionsformen, wobei die Matrize umfasst:

eine erste Fläche;
eine zweite Fläche, die gegenüber der ersten Fläche ausgebildet ist;
einen Rohmaterial-Zufuhrabschnitt mit einer ersten Durchgangsöffnung, die sich von der ersten Fläche zur zweiten Fläche erstreckt; und
einen Formabschnitt mit einer zweiten Durchgangsöffnung, die sich von der zweiten Fläche zur ersten Fläche erstreckt, um mit der zweiten Fläche in Verbindung zu stehen,

wobei das Verfahren folgende Schritte umfasst:

Bearbeiten des Materials der Matrize zum Ausbilden des Materials in eine vorgegebene Form und zum Ausbilden einer der Bearbeitung unterzogenen Schicht auf der Innenwandfläche der zweiten Durchgangsöffnung im Formabschnitt;
Ausbilden einer oxidierten Schicht durch Erhitzen der der Bearbeitung unterworfenen Schicht, um die Schicht zu oxidieren, um die der Bearbeitung unterzogene Schicht in eine oxidierte Schicht umzuwandeln;
Entfernen der oxidierten Schicht, sodass die behandelte Oberfläche ausgebildet wird; und
Nitrieren der behandelten Oberfläche durch eine Ionenimplantation zum Ausbilden einer Nitridschicht

**11.** Verfahren nach Anspruch 10,
wobei der Bearbeitungsschritt durch eine Senk-Funkenerosionsbearbeitung ausgeführt wird.

**12.** Verfahren nach Anspruch 10 oder 11,
wobei im Schritt des Ausbildens einer Oxidationsschicht die der Bearbeitung unterzogene Schicht auf eine Temperatur von 500 bis 1000°C in einer Sauerstoffatmosphäre erhitzt wird.

**13.** Verfahren nach Anspruch 10 oder 11,
wobei im Schritt des Ausbildens einer Oxidationsschicht die der Bearbeitung unterzogene Schicht auf eine vorgegebene Temperatur von 500 bis 1000°C in einer Stickstoffatmosphäre erhitzt wird; und
die der Bearbeitung unterzogene erhitzte Schicht 5 bis 180 Minuten bei der vorgegebenen Temperatur in einer Sauerstoffatmosphäre stehen gelassen wird.

**14.** Verfahren nach einem der Ansprüche 10 bis 13,
wobei der Schritt des Entfernens der oxidierten Schicht durch Strahl-Polieren (Flow-Polishing) ausgeführt wird.

**15.** Verfahren zum Herstellen eines Wabenstrukturkörpers, das folgende Schritte umfasst:

Extrusionsformen eines Form-Rohmaterials durch eine Matrize zum Extrusionsformen, um zumindest einen Wabenformkörper herzustellen, der eine große Anzahl von Zellen aufweist, wobei die Zellen durch Zellwände getrennt sind und in Längsrichtung parallel zueinander angeordnet sind;
Brennen des zumindest einen Wabenformkörpers zum Herstellen zumindest eines gebrannten Wabenformkörpers; und
Herstellen eines Keramikblocks aus dem zumindest einen gebrannten Wabenformkörper,

wobei die Matrize umfasst:

eine erste Fläche;

eine zweite Fläche, die gegenüber der ersten Fläche ausgebildet ist;
einen Rohmaterial-Zufuhrabschnitt mit einer ersten Durchgangsöffnung, die sich von der ersten Fläche zur zweiten Fläche erstreckt; und
einen Formabschnitt mit einer zweiten Durchgangsöffnung, die sich von der zweiten Fläche zur ersten Fläche erstreckt, um mit der zweiten Fläche in Verbindung zu stehen,

wobei die Matrize durch folgende Schritte erhaltbar ist:

Bearbeiten des Materials der Matrize zum Ausbilden des Materials in eine vorgegebene Form und zum Ausbilden einer der Bearbeitung unterzogenen Schicht auf der Innenwandfläche der zweiten Durchgangsöffnung im Formabschnitt;
Ausbilden einer oxidierten Schicht durch Erhitzen der der Bearbeitung unterworfenen Schicht, um die Schicht zu oxidieren, um die der Bearbeitung unterzogene Schicht in eine oxidierte Schicht umzuwandeln;
Entfernen der oxidierten Schicht, sodass die behandelte Oberfläche ausgebildet wird; und
Nitrieren der behandelten Oberfläche durch eine Ionenimplantation zum Ausbilden einer Nitridschicht.

**Revendications**

1. Filière pour moulage par extrusion comprenant :

   une première face ;
   une deuxième face formée à l'opposé de la première face ;
   une section d'alimentation en matière première ayant un premier trou traversant qui s'étend depuis la première face vers la deuxième face ; et
   une section de moulage ayant un deuxième trou traversant qui s'étend depuis la deuxième face vers la première face de façon à communiquer avec le premier trou traversant,

   dans laquelle la filière peut être obtenue par les étapes consistant :

   à usiner une matière de la filière pour façonner la matière sous une forme prédéterminée et pour former une couche affectée par l'usinage sur la surface de paroi interne du deuxième trou traversant dans la section de moulage ;
   à former une couche oxydée en chauffant la couche affectée par l'usinage pour oxyder la couche afin de transformer la couche affectée par l'usinage en la couche oxydée ;
   à retirer la couche oxydée de sorte qu'une surface traitée soit formée ; et
   à nitrurer la surface traitée par implantation ionique pour former une couche de nitrure.

2. Filière selon la revendication 1,
   dans laquelle la section d'alimentation en matière première comprend en outre une première ouverture formée au niveau de la première face et une deuxième ouverture formée au niveau d'une partie où le deuxième trou traversant communique avec le premier trou traversant, et
   la largeur de la section d'alimentation en matière première diminue depuis la première ouverture vers la deuxième ouverture.

3. Filière selon la revendication 1 ou 2,
   dans laquelle la section de moulage comprend des rainures fendues qui communiquent avec une pluralité de deuxième trou traversant, les rainures fendues se reliant les unes aux autres pour former un motif en réseau.

4. Filière selon l'une quelconque des revendications 1 à 3, pouvant être obtenue en outre par les étapes consistant :

   à usiner une matière de la filière pour façonner la matière sous une forme prédéterminée et pour former une couche affectée par l'usinage sur la surface de paroi interne du premier trou traversant dans la section d'alimentation en matière première ;
   à former une couche oxydée en chauffant la couche affectée par l'usinage pour oxyder la couche afin de transformer la couche affectée par l'usinage en une couche oxydée ;
   à retirer la couche oxydée de sorte qu'une surface traitée soit formée ; et
   à nitrurer la surface traitée par implantation ionique pour former une couche de nitrure.

**5.** Filière selon l'une quelconque des revendications 1 à 4,
dans laquelle la couche de nitrure a une épaisseur allant de 5 à 1000 nm.

**6.** Filière selon l'une quelconque des revendications 1 à 5,
dans laquelle la couche de nitrure a une dureté allant de 1200 à 3000 Hv.

**7.** Filière selon l'une quelconque des revendications 1 à 6,
dans laquelle la filière est réalisée en un alliage extra-dur qui comprend un mélange fritté de carbure de tungstène et de cobalt, et
la couche de nitrure comprend du carbonitrure de tungstène.

**8.** Filière selon l'une quelconque des revendications 1 à 7,
dans laquelle l'étape consistant à retirer la couche oxydée est réalisée par polissage par écoulement.

**9.** Filière selon l'une quelconque des revendications 1 à 8,
dans laquelle une matière première de moulage devant être introduite dans l'unité d'alimentation en matière première comprend du carbure de silicium.

**10.** Procédé de production d'une filière pour moulage par extrusion, la filière comprenant :

une première face ;
une deuxième face formée à l'opposé de la première face ;
une section d'alimentation en matière première ayant un premier trou traversant qui s'étend depuis la première face vers la deuxième face ; et
une section de moulage ayant un deuxième trou traversant qui s'étend depuis la deuxième face vers la première face de façon à communiquer avec le premier trou traversant,

le procédé comprenant les étapes consistant :

à usiner une matière de la filière pour façonner la matière sous une forme prédéterminée et pour former une couche affectée par l'usinage sur la surface de paroi interne du deuxième trou traversant dans la section de moulage ;
à former une couche oxydée en chauffant la couche affectée par l'usinage pour oxyder la couche afin de transformer la couche affectée par l'usinage en une couche oxydée ;
à retirer la couche oxydée de sorte qu'une surface traitée soit formée ; et
à nitrurer la surface traitée par implantation ionique pour former une couche de nitrure.

**11.** Procédé selon la revendication 10,
dans lequel l'étape d'usinage est réalisée par usinage par électroérosion à enfonçage.

**12.** Procédé selon la revendication 10 ou 11,
dans lequel, dans l'étape de formation d'une couche oxydée, la couche affectée par l'usinage est chauffée à une température allant de 500 à 1000°C dans une atmosphère d'oxygène.

**13.** Procédé selon la revendication 10 ou 11,
dans lequel, dans l'étape de formation d'une couche oxydée, la couche affectée par l'usinage est chauffée à une température prédéterminée allant de 500 à 1000°C dans une atmosphère d'azote ; et
la couche affectée par l'usinage chauffée est laissée au repos à la température prédéterminée dans une atmosphère d'oxygène pendant 5 à 180 minutes.

**14.** Procédé selon l'une quelconque des revendications 10 à 13,
dans lequel l'étape consistant à retirer la couche oxydée est réalisée par polissage par écoulement.

**15.** Procédé de production d'un corps structuré en nid d'abeilles comprenant les étapes consistant :

à mouler par extrusion une matière première de moulage à travers une filière pour moulage par extrusion afin de produire au moins un corps moulé en nid d'abeilles qui comprend un grand nombre de cellules, les cellules étant séparées par des parois cellulaires et agencées parallèlement les unes aux autres dans une direction longitudinale ;

à cuire l'au moins un corps moulé en nid d'abeilles pour produire au moins un corps cuit en nid d'abeilles ; et

à produire un bloc céramique de l'au moins un corps cuit en nid d'abeilles,

la filière comprenant:

une première face ;

une deuxième face formée à l'opposé de la première face ;

une section d'alimentation en matière première ayant un premier trou traversant qui s'étend depuis la première face vers la deuxième face ; et

une section de moulage ayant un deuxième trou traversant qui s'étend depuis la deuxième face vers la première face de façon à communiquer avec le premier trou traversant,

où la filière peut être obtenue par les étapes consistant :

à usiner une matière de la filière pour façonner la matière sous une forme prédéterminée et pour former une couche affectée par l'usinage sur la surface de paroi interne du deuxième trou traversant dans la section de moulage ;

à former une couche oxydée en chauffant la couche affectée par l'usinage pour oxyder la couche afin de transformer la couche affectée par l'usinage en une couche oxydée ;

à retirer la couche oxydée de sorte qu'une surface traitée soit formée ; et

à nitrurer la surface traitée par implantation ionique pour former une couche de nitrure.

# FIG.1

(a)

(b)

## FIG.2

## FIG.3

## FIG.4

# FIG.5

(a)

(b)

(c)

(d)

## FIG.6

## FIG.7

# FIG.8

(a)

(b)

A-A line cross-sectional view

FIG.9

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP H05131425 A